Europäisches Patentamt

European Patent Office

Office européen des brevets

(11) Publication number: **0 342 812**
**A2**

# (12) EUROPEAN PATENT APPLICATION

(21) Application number: 89304360.4

(51) Int. Cl.4: **G03C 1/68**

(22) Date of filing: 28.04.89

(30) Priority: 16.05.88 GB 8811588

(43) Date of publication of application:
23.11.89 Bulletin 89/47

(84) Designated Contracting States:
AT BE CH DE ES FR GB GR IT LI LU NL SE

(71) Applicant: IMPERIAL CHEMICAL INDUSTRIES PLC
Imperial Chemical House Millbank
London SW1P 3JF(GB)

(72) Inventor: Fitchett, Mark
63 The Rock
Helsby Cheshire WA6 9AS(GB)
Inventor: Gibson, David Robert
11 Oakdale road
Mossley Hill Liverpool L18 1EP(GB)
Inventor: Dudman, Christopher Curtis
4 St. James Avenue
Upton Chester CH2 1NA(GB)
Inventor: Patel, Chimanlal Gandabhai
11 Penketh Road Gt. Sankey
Warrington Cheshire(GB)

(74) Representative: Sheller, Alan et al
Imperial Chemical Industries PLC Legal
Department: Patents PO Box 6
Welwyn Garden City Herts, AL7 1HD(GB)

(54) **Photopolymerisable compositions suitable for recording holographic information.**

(57) An aqueous-based, film-forming, photopolymerisable composition is described, said composition comprising at least a polymer binder, a polymerisable ethylenically unsaturated monomer and a photoinitiator. The photopolymerisable composition may be formed into a photosensitive film and then exposed to actinic radiation bearing holographic information in order to form a holographic image.

EP 0 342 812 A2

# PHOTOPOLYMERISABLE COMPOSITIONS SUITABLE FOR RECORDING HOLOGRAPHIC INFORMATION

The present invention relates, particularly, to the field of holography, being concerned with aqueous based photopolymerisable compositions which, after removal of the aqueous phase to form a photosensitive element, are capable of recording holographic information in the form of hologram masters or recorded copies, as volume phase holograms.

Holography is a means of recording the optical information reflected from, or transmitted by, an object when illuminated by highly monochromatic and coherent light, for example, light emitted from a laser source. The techniques available for forming holographic images are well known to those skilled in the art.

A hologram may be classified depending on how it stores the holographic information it contains. The two main classes are amplitude holograms and phase holograms. Phase holograms tend to be preferred since the efficiency with which the reference beam is transformed into the reconstructed object beam, referred to as the diffraction efficiency, is generally much higher. With phase holograms diffraction efficiencies of up to 100% are theoretically achievable, although for holograms of complex wavefronts it is generally not possible to achieve diffraction efficiencies which even approach this theoretical maximum.

Holograms may be further divided into thin (surface) holograms and thick (volume) holograms. A thick hologram denotes a hologram in which the hologram thickness is much greater than the spacing between the adjacent interference fringes. Thick holograms tend to have a higher diffraction efficiency and, therefore, can provide clear holographic images of high intensity. Thick holograms also tend to be very wavelength and angle selective which renders them suitable for other optical applications.

Accordingly, thick (volume) phase holograms have certain distinct advantages in that they provide for high diffraction efficiencies and, therefore, clear holographic images of high intensity.

Holography has a wide range of applications, the most obvious of which is the production of three dimensional images for display purposes. Holographic technology has also found application in the manufacture of optical elements, such as the holographic lens. Modern head up displays (HUD) in aircraft use holographic optical elements. Holography also finds application in the manufacture of holographic diffraction gratings which may be used in demultiplexers to separate different wavelengths in optical fibre communications. Other applications for holography include optical data storage, image processing, and holographic interferometry.

For the production of high quality holograms of good resolution, it is necessary to employ a holographic recording medium that is capable of reproducing fine details, and this, in turn, requires that the medium be capable of recording, accurately, a large number of lines per linear unit. This property, referred to as the spatial frequency, relates to the ability of the holographic medium to record a complicated pattern of closely spaced interference fringes and is commonly expressed in units of lines per millimetre (lines/mm). A good holographic recording medium should also provide a high diffraction efficiency and be substantially free of light scattering centres. Furthermore, for the recording of master holograms the holographic recording medium should be of relatively high speed enabling short exposure times to be employed.

In circumstances where there is a need to produce a number of copies of a given hologram, it is both expensive and time consuming to prepare each hologram as a hologram master. However, it is possible to take copies from a hologram master using essentially conventional contact printing techniques. In order to make good hologram copies which display the quality and resolution of the original, the holographic recording medium must, of course, be able to record the spatial frequencies present in the hologram master, should have a good diffraction efficiency and should be substantially free of light scattering centres.

Many materials have been employed in the manufacture of hologram masters and hologram copies which at least in part satisfy the requirements for good holographic recording media discussed supra. The four most commonly used are silver halide, dichromated gelatin, photoresists and thermoplastics.

One of the major disadvantages with many of the holographic recording media discussed so far, is the requirement for a wet processing step to develop and fix the holographic image formed from the initial imagewise exposure. Such processing is both time consuming and expensive, and it also delays the availability of the final holographic image. It is known that certain photopolymerisable materials may be used as holographic recording media for the making of hologram masters and copies. Materials in this realm typically comprise an organic solvent in which is dissolved a polymeric binder, an ethylenically unsaturated polymerisable monomer, and a photoinitiator activatable by actinic radiation to initiate the polymerisation of the said monomer. These materials can be cast to form photosensitive films which are then exposed to actinic radiation bearing holographic information. During the imagewise exposure to actinic radiation bearing holographic information, it is believed that the photoinitiator is activated in the exposed areas corresponding to the interference pattern, which leads to monomer polymerisation in those areas. A subsequent uniform non-imagewise exposure may be employed to fix the holographic image by causing the polymerisation of the remaining monomer. It is disclosed that this subsequent non-imagewise exposure is not necessary although it may often be desirable.

While photopolymerisable systems of this kind obviously have distinct advantages in view of their relative cheapness, and the fact that no wet processing is required to develop and fix the holographic image, certain problems have limited their acceptance in comparison to other holographic recording media. These problems include, inter alia, shelf life, low sensitivities opposite silver halide films and, therefore, slow speed, modest refractive index modulation, stability of the holographic image with time, temperature stability and irreversibility. Therefore, there is a need for photopolymerisable holographic recording medium which can overcome at least some of these problems, and have the advantage of needing no wet processing. It would be particularly advantageous to develop a photopolymerisable holographic recording medium with good sensitivity to visible wavelengths.

We have now found that certain photopolymerisable compositions can be formed into photosensitive elements that in one embodiment are capable of retaining the holographic information contained in an imagewise exposure of actinic radiation without a subsequent non-imagewise exposure being necessary to fix the image, and while such a subsequent exposure is preferable, in either alternative, the need for expensive and time consuming wet processing techniques is avoided, and the hologram is readily available for use. The photosensitive elements are capable of displaying high sensitivities and fast speeds, so that short exposure times are attainable. Furthermore, photosensitive elements that are sensitive to visible wavelengths have been developed, for example, photosensitive elements have been prepared which are sensitive to the Argon Ion laser which emits visible blue light (wavelength 488nm). Photosensitive films formed from the photopolymerisable compositions may be self-supporting, exhibit a good shelf life and a resistance to shrinkage during exposure. After exposure to form a hologram, the photosensitive films are capable of providing mechanically strong, self supporting films containing the holographic information. The exposed holographic films may exhibit good temperature stability (e.g., they may remain stable up to at least 140°C) and time stability (in the sense that they are capable of retaining the holographic information for long periods of time) and, furthermore, may exhibit both solvent and water resistance. The photosensitive films may provide volume phase holograms, in the reflection or transmission mode, which exhibit a number of favourable properties; these include, inter alia, high resolution, high diffraction efficiency (e.g., at least up to 95%), high spatial frequency (for example, at least up to 1000 lines/mm), low scatter, and good refractive index modulation (i.e. a good variation between the refractive indices of the originally exposed and unexposed areas), so that good clear holographic images are attainable.

According to the present invention there is provided the use of an aqueous based, film-forming photopolymerisable composition for the formation of photosensitive elements on which image information is to be recorded said composition comprising:

A) an aqueous latex of a film-forming polymeric binder said binder comprising at least one film-forming copolymer formed by addition polymerisation, said film-forming copolymer comprising polymerised units derived from at least one ethylenically unsaturated comonomer which provides the basis of film-formability in said copolymer;

B) at least one non-gaseous, ethylenically unsaturated monomeric compound compatible with the polymeric binder of (A) and which is capable of forming a polymer by free-radical initiated addition polymerisation; and

C) at least one free radical generating photoinitiator or photoinitiating system activatable by a source of actinic radiation for the polymerisation of the at least one monomer of (B).

The photopolymerisable compositions for use in accordance with the present invention are aqueous based compositions comprising in mixture, an aqueous latex of a film-forming polymeric binder, at least one polymerisable monomer, and at least one free radical generating photoinitiator or photoinitiating system.

The polymeric binder comprises at least one film-forming copolymer which may be formed by well established addition copolymerisation techniques. For example, the copolymer may be formed by emulsion copolymerisation in an aqueous medium with the aid of a free radical generating initiator and usually in the presence of a surface active agent (i.e. surfactant), to yield an aqueous latex. Alternatively, the aqueous latex of the film-forming polymeric binder may be formed by post-emulsification (in water) of at least one pre-formed solid copolymer prepared by any suitable addition polymerisation technique, for example, by free radical, anionic, or cationic addition polymerisation. In preferred embodiments the size of the polymer particles in the aqueous latex of the polymeric binder is in the range of from 0.02 μm to 0.8 μm, more preferably in the range of from 0.05 μm to 0.4 μm, and especially in the range of from 0.05 μm to 0.2 μm. In preferred embodiments the at least one film-forming copolymer of the polymeric binder has a low

3

refractive index. In further preferred embodiments, the at least one film-forming copolymer of the polymeric binder is of high molecular weight, for example, a molecular weight in excess of 30,000, preferably in excess of 50,000, for example, 100,000. Film-forming copolymers having a glass transition temperature (Tg) in the range -40°C to 50°C are typically employed, preferably in the range -20°C to 30°C, and particularly preferably in the range 0°C to 15°C, since the film-forming properties of such a copolymer are particularly suitable. If a film-forming copolymer of Tg below -40°C is employed, then photosensitive films cast from the photopolymerisable compositions tend to be somewhat soft, sticky or tacky. Conversely, if film-forming copolymers of Tg above 50°C are employed then problems can arise during film formation, and the photosensitive films may be brittle and non-coherent. By controlling the Tg of the film-forming copolymer, the formation of photosensitive films and the formation of the image, may both be carried out at convenient operating temperatures, for example, at or around ambient temperature.

The film-forming copolymer comprises polymerised units derived from at least one ethylenically unsaturated comonomer which provides the basis of film-formability in said copolymer (the film-forming comonomer(s)). In preferred embodiments the film-forming copolymer comprises polymerised units derived from one or more monoethylenically unsaturated monomers of the film-forming type containing an olefinic, vinyl, vinylidene, acrylic or methacrylic double bond. Suitable monomers in this realm include, inter alia, vinyl chloride, vinylidene chloride, vinyl esters of alkanoic acids having from 1 to 18 carbon atoms in the alkyl group, alkyl acrylates and methacrylates having from 1 to 18 carbon atoms in the alkyl group, vinyl ethers, acrylamide and substituted acrylamides, acrylonitrile and methacrylonitrile, monoethylenically unsaturated hydrocarbons, for example, ethylene, isobutene, styrene and alpha methyl styrene.

The Tg of the film-forming copolymer may be controlled by appropriate selection of the types and amounts of monomers used in the formation thereof. Further control over the Tg may also be exercised by including at least one external plasticiser in the aqueous latex of the polymeric binder, so that a copolymer with a Tg in the ranges specified supra is readily attainable.

External plasticisers which may optionally be employed in the compositions of the invention, include esters of polycarboxylic acids such as phthalic acid, isophthalic acid, terephthalic acid, adipic acid, azalaic acid, sebacic acid, and mellitic acid. Phosphoric acid esters, such as trioctyl phosphate, tricresyl phosphate, tritolyl phosphate, and trixylyl phosphate, and polyester plasticisers such as polypropylene laurate, soya bean oil derived plasticisers such as epoxidised soya bean oil, and chlorinated paraffins may also be used. Other suitable plasticisers include the alkyl esters of dicarboxylic acids, examples of which include dibutyl phthalate, dihexyl phthalate, dioctyl phthalate, di-iso-octyl phthalate, and dinonyl phthalate. The amount of the at least one external plasticiser, if included, will depend, inter alia, on the Tg of the film-forming copolymer prior to adding the at least one external plasticiser.

The present invention is particularly advantageous when the film-forming copolymer of the polymeric binder is a chlorine containing copolymer comprising polymerised units of at least one chlorine containing comonomer therein. In preferred embodiments according to the present invention, the film-forming copolymer will usually comprise from 5 to 95 % by weight, preferably from 25 to 95 % by weight, and particularly preferably from 30 to 90 % by weight of polymerised units derived from the at least one chlorine containing comonomer. The most preferred chlorine containing comonomers are vinylidene chloride and vinyl chloride which may be used alone or in combination with each other and/or with other chlorine containing comonomers. In preferred embodiments of the invention, the chlorine content (if present) of the film-forming copolymer will be entirely derived from polymerised units of vinylidene chloride and/or vinyl chloride.

Accordingly, further preferred film-forming copolymers for use in the polymeric binder of the invention comprise 5 to 95 % by weight of polymerised units derived from vinylidene chloride and/or vinyl chloride, and 5 to 95 % by weight of polymerised units of one or more other comonomers.

The most preferred chlorine containing comonomer is vinylidene chloride and, therefore, according to further preferred embodiments of the invention, polymerised units of vinylidene chloride will provide at least 50 % (i.e. from 50 % up to 100 %) by weight of the total chlorine containing comonomer content of the copolymer, with polymerised units of vinyl chloride providing the remainder. In the preferred vinylidene chloride/vinyl chloride containing film-forming copolymers, at least a proportion of the polymerised units of the non-chlorine containing comonomer(s) should comprise units derived from at least one alkyl acrylate and/or methacrylate (preferably acrylate), preferably at least one alkyl acrylate and/or methacrylate having 1 to 12 (particularly preferably 2 to 10, for example, 2 to 8) carbon atoms in the alkyl group. In preferred embodiments, at least one of the at least one alkyl acrylate and/or methacrylate (if used) will be an internally plasticising comonomer. Examples of internally plasticising alkyl acrylates and methacrylates include, inter alia, n-butyl acrylate, 2-ethylhexyl acrylate, n-decyl methacrylate, n-octyl acrylate, 2-ethylbutyl acrylate, n-heptyl acrylate, 2-heptyl acrylate, n-hexyl acrylate, 3-methylbutyl acrylate, n-nonyl acrylate, 2-

4

octyl acrylate, and n-propyl acrylate. Particularly preferred comonomers are n-butyl acrylate and 2-ethylhexyl acrylate (both internally plasticising comonomers), and the vinylidene chloride/vinyl chloride containing copolymer used in preferred embodiments of the invention, may comprise one or both of these comonomers as the sole alkyl (meth)acrylate(s) and plasticising comonomer(s) therein, although, of course, one or more other alkyl (meth)acrylates, and/or one or more other internally plasticising comonomers may also be used in combination therewith. Other suitable non-chlorine containing comonomers for use in the preferred vinylidene chloride/vinyl chloride containing film-forming copolymers of the invention, include, inter alia, acrylic acid, methacrylic acid, acrylonitrile and methacrylonitrile.

By an internally plasticising comonomer is meant a comonomer which gives a homopolymer (when polymerised alone) of very low Tg, preferably -40°C and below, more preferably -50°C and below, and so provides copolymerised units in a copolymer which if present in sufficient proportion tend to cause the copolymer to be intrinsically plasticised and thereby have considerably lowered Tg in comparison to a polymer not having such units. Thus, the use of such comonomers may allow Tg's in the preferred ranges to be readily achieved. Suitable internally plasticising comonomers, other than the internally plasticising alkyl acrylates and methacrylates already mentioned include, inter alia, certain kinds of alkoxyalkyl acrylates and methacrylates, such as 1-ethoxyethyl acrylate, 1-ethoxypropyl acrylate, 2-methoxyethyl acrylate, 3-methoxypropyl acrylate, and propoxylated acrylates and methacrylates, and other monomers such as ethylene, 1,3-butadiene, isoprene, chloroprene, 1-decene, 1-pentene, 1-octene, and nuclear substituted styrenes such as 4-dodecyl styrene, 4-nonyl styrene, and the 4-alkylsulphonyl styrenes.

The film-forming copolymer preferably contains polymerised units derived from at least one multi-functional comonomer that has effected a partial (in the sense of a degree of) cross linking during the polymerisation reaction to form the copolymer (resulting in the formation of some insoluble gel), as this may improve the performance of photosensitive films formed from the photopolymerisable compositions. By the gel fraction of the copolymer is meant the percentage by weight of cross linked material in the copolymer; this is usually determinable by extraction using a solvent under conditions which dissolves the corresponding uncross-linked fraction of the copolymer (found, for example, with the aid of a similar copolymer that is known to have been prepared without any possibility for crosslinking) and measuring the weight of the insoluble portion of the copolymer. In the present invention the film-forming copolymer will preferably have a gel fraction in the range of from 5 to 80 % by weight, more preferably in the range of from to 70 % by weight. By the term multi-functional in respect of said multi-functional comonomer is meant a comonomer having at least two unsaturated carbon to carbon double bonds which can each (i.e. independently) take part in a free-radical initiated addition copolymerisation reaction. In order to achieve a degree of cross linking in the film-forming copolymer, at least one multi-functional comonomer must be added to the polymerisation reaction in at least an early part thereof; usually, said at least one multi-functional comonomer, at least in part, is added within (i.e. has been added by the end of) the first 70 % conversion of monomers to copolymer reached in the copolymerisation (preferably by the end of 60 % conversion, often by the end of 50 % conversion or by the end of the first 40 % conversion reached). This is in order to allow enough of both carbon to carbon double bonds in each molecule to react to yield the required cross linking. To achieve the residual cross linking, the at least one multi-functional comonomer used in the copolymerisation may have at least one of its carbon to carbon double bonds (in the molecule) of significantly lower reactivity than the carbon to carbon double bond(s) of the film-forming comonomer(s). Such a multi-functional comonomer is hereinafter termed a lower reactivity multi-functional comonomer for convenience. Alternatively, if desired, each double bond of the at least one multi-functional comonomer may have the same order of, or even higher, reactivity as the double bond(s) of the film forming comonomer(s). Such a multi-functional comonomer is hereinafter termed a higher reactivity multi-functional comonomer for convenience. A combination of at least one lower reactivity multi-functional comonomer and at least one higher reactivity multi-functional comonomer may also be employed. Examples of suitable multi-functional comonomers (if used) for use in providing a cross linked, film-forming copolymer include, inter alia, lower reactivity types such as diallyl esters of aromatic diols such as diallyl phthalate and mono- and diallyl esters of alpha beta-unsaturated mono- and dicarboxylic acids, such as allyl methacrylate, allyl acrylate, diallyl maleate, diallyl fumarate, and diallyl itaconate, and higher reactivity types such as 1,3-butylene glycol dimethacrylate, ethylene glycol diacrylate, ethylene glycol dimethacrylate, and divinyl benzene. The preferred multi-functional comonomers, if used, are diallyl phthalate and allyl methacrylate. The film-forming copolymer of the polymeric binder preferably contains from 0.1 to 20 % by weight, more preferably from 0.2 to 8 % by weight, and particularly preferably from 0.2 to 4 % by weight of polymerised units derived from the at least one multi-functional comonomer incorporated to provide cross linking if such a comonomer is employed.

Besides optionally including polymerised units derived from at least one multi-functional comonomer

5

which causes cross-linking during polymerisation, the at least one film-forming copolymer may also comprise polymerised units derived from at least one multi-functional comonomer which provides residual carbon to carbon double bond (i.e. ethylenic) unsaturation in the copolymer for cross linking (during exposure to form the image) with itself and/or with the at least one polymerisable ethylenically unsaturated monomer. To achieve such residual unsaturation (for cross linking during image formation), a multi-functional comonomer employed in the copolymerisation reaction to form the film-forming copolymer should have at least one of its carbon to carbon double bonds (in a molecule thereof) of a reactivity such that it or they react(s) in the copolymerisation at a significantly slower rate than does the unsaturated bond(s) of the film-forming comonomer(s) (i.e. a lower reactivity multi-functional comonomer). Preferably, the multi-functional comonomer which may optionally be employed to provide residual unsaturation contains one or more allyl groups $CH_2 = CHCH_2-$ (or, possibly, monosubstituted allyl groups $RCH = CHCH_2-$ where R is an appropriate substituent such as a lower (C1 to C4) alkyl group, e.g., methyl or ethyl), since the double bond of such groups is of low reactivity and generally speaking slower reacting than the unsaturated bonds of most film-forming comonomers. In order to provide the optional residual unsaturation in the resulting film-forming copolymer, the at least one lower reactivity multi-functional comonomer must be added to the copolymerisation reaction in at least a late part thereof; usually said at least one lower reactivity multi-functional comonomer is added, at least in part, to the copolymerisation reaction after at least 70 % conversion has been reached (preferably within 70 to 95 %, more preferably 70 to 90 % conversion). Suitable lower reactivity multi-functional comonomers (for providing residual unsaturation) have already been listed supra, in connection with lower reactivity multi-functional comonomers suitable for providing a cross linked film-forming copolymer during polymerisation thereof. The film-forming copolymer of the polymeric binder may contain from 0.1 to 10 % by weight, for example, from 0.2 to 8 % by weight, say from 0.2 to 4 % by weight of polymerised units derived from the at least one lower reactivity multi-functional comonomer incorporated to provide residual unsaturation if such a comonomer is employed.

Alternatively, it may also be possible to provide the said residual unsaturation by means of a post reaction step, wherein the film-forming copolymer once formed is subjected to a further reaction(s) which introduces the said residual unsaturation. For this purpose it is necessary to prepare a film-forming copolymer having reactive groups which will react under appropriate conditions, in a post reaction step, with a co-reactive group of an ethylenically unsaturated compound which is to be used to introduce the residual ethylenic unsaturation. For example, a copolymer having carboxylic acid, hydroxyl, or amine functionalities can be reacted with an ethylenically unsaturated epoxide or aziridine in order to introduce residual ethylenic unsaturation into the film-forming copolymer.

The preparation of crosslinked film-forming copolymers which may also comprise residual ethylenic unsaturation is more fully described in the present applicants European patent application (Publication no. 232016), the disclosure in which is incorporated herein by way of reference.

In addition to the film-forming copolymer, the polymeric binder of the present invention may also if desired include one or more other types of polymer (i.e. of the non-film forming type) incorporated preformed into the composition, for example, by adding an aqueous emulsion of such a polymer to the already formed aqueous latex of the polymeric binder, or, more preferably, by performing the polymerisation to form the film-forming copolymer in the presence of an aqueous emulsion of such a polymer. However, the presence of an additional non-film forming polymer is generally not preferred, and where it is included, the at least one film-forming copolymer will comprise a substantial proportion (i.e. at least 50 %, preferably at least 60 % and more preferably at least 90 %) of the total polymer content of the polymeric binder, so as to render the polymeric binder film-forming overall. The polymeric binder may, of course, comprise two or more film-forming copolymers any number of which may comprise residual cross linking and/or residual carbon to carbon double bond unsaturation.

The photopolymerisable composition for use in the present invention employs at least one polymerisable monomer, which will polymerise (to form a photo-polymer) during exposure of a photosensitive element, such as a photosensitive film (formed from said photopolymerisable composition), to form the image (i.e component (B) of the photopolymerisable composition). The practice of the present invention is not limited to the use of any particular polymerisable monomer, it being required only that the at least one polymerisable monomer be non-gaseous, ethylenically unsaturated, capable of addition polymerisation, and compatible with the polymeric binder. Monomers are said to be compatible with the polymeric binder if they swell the latex particles and do not phase separate from the polymerisable compositions when in the dry, uncured state (i.e after removal of the aqueous phase but prior to imagewise exposure). In some circumstances, the polymerisable monomer may also serve as a plasticiser for the polymeric binder. Furthermore, the present invention is not limited to the use of photopolymerisable compositions having just one polymerisable monomer and, indeed, it may often be advantageous to use a combination of two or more copolymerisable monomers. Component (B) may comprise both mono-functional (i.e. monoethylenically unsaturated) monomers and multi-functional monomers (i.e.monomers having at least two unsaturated carbon to carbon (ethylenic) double bonds which can each, independently, take part in a free radical initiated addition polymerisation reaction). The polymerisable monomers are preferably of high refractive index, so that the photo-polymer formed therefrom will have a refractive index above that of the film-forming copolymer of the polymeric binder.

According to preferred embodiments of the invention component (B) of the photopolymerisable composition will comprise two or more ethylenically unsaturated copolymerisable monomers, wherein at least one of the said monomers is a mono-functional monomer and at least one of the said monomers is a multi-functional monomer. Where a polymerisable monomer system is employed which comprises at least one multi-functional polymerisable comonomer, the resulting photo-copolymer that forms during exposure to actinic radiation to produce the image, may possess a degree of cross-linking. Therefore, the resulting photo-copolymer may achieve a high molecular weight and/or a high degree of network formation at low degrees of conversion, which may enhance the quality of the image. Furthermore, multi-functional monomers provide the possibility of cross-linking between the film-forming copolymer of the polymeric binder (if the said film-forming copolymer contains residual unsaturation) and the photo-copolymer.

The preferred monoethylenically unsaturated polymerisable monomers for use in component (B) are the acrylic or methacrylic functional monomers, i.e those monomers in which the carbon to carbon double bond is an acrylic or methacrylic double bond. Particularly preferred monomers in this realm include the alkyl acrylates and methacrylates having from 1 to 12 (preferably 1 to 10 and more preferably 2 to 8) carbon atoms in the alkyl group, alkoxyalkyl and hydroxyalkyl acrylates and methacrylates having from 1 to 12 (preferably 1 to 10 and more preferably 2 to 8) carbon atoms in the alkyl group, and substituted alkyl acrylates and methacrylates having from 1 to 12 (preferably 1 to 10 and more preferably 2 to 8) carbon atoms in the alkyl group. Examples of such alkyl acrylates and methacrylates include, inter alia, n-butyl acrylate and methacrylate, sec-butyl acrylate, tert-butyl acrylate, cyclohexyl acrylate and methacrylate, n-dodecyl acrylate and methacrylate, ethyl acrylate and methacrylate, 2-ethylbutyl acrylate, n-heptyl acrylate, n-hexyl acrylate, isobutyl acrylate and methacrylate, isopropyl acrylate and methacrylate, methyl acrylate and methacrylate, 2-methylbutyl acrylate, 3-methylbutyl acrylate, n-octyl acrylate and methacrylate, 2-octyl acrylate, 3-pentyl acrylate and methacrylate, n-propyl acrylate, and 2-ethylhexyl acrylate and methacrylate. Examples of such alkoxyalkyl and hydroxy alkyl acrylates and methacrylates include, inter alia, 1-ethoxyethyl acrylate, 1-ethoxypropyl acrylate, 2-methoxyethyl acrylate, 3-methoxy propyl acrylate, ethoxyethoxyethyl acrylate, hydroxypropyl methacrylate, hydroxyethyl acrylate and methacrylate. Examples of such substituted alkyl acrylates and methacrylates include, inter alia, 2-phenylethyl acrylate, methylaminoethyl acrylate and methacrylate, tert-butylaminoethyl acrylate and methacrylate. Other suitable monoethylenically unsaturated acrylic or methacrylic functional monomers include, inter alia, acrylic and methacrylic acids, acrylamide and methacrylamide, acrylonitrile and methacrylonitrile, alkoxyalkyl acrylamides and methacrylamides, such as butoxymethyl acrylamide and methoxymethyl methacrylamide, and hydroxyalkyl acrylamides and methacrylamides, such as N-methylol methacrylamide and N-methylol acrylamide.

The preferred multi-functional monomers for use in component (B) are those monomers in which at least one of the carbon to carbon double bonds in the monomer is an acrylic or methacrylic double bond. Examples of such monomers include, inter alia, trimethylol propane triacrylate, di-trimethylol propane triacrylate, 1,3-butylene glycol dimethacrylate, ethylene glycol diacrylate, ethylene glycol dimethacrylate, diethylene glycol dimethacrylate, triethylene glycol dimethacrylate, trimethylene glycol dimethacrylate, triethoxylated trimethylol propane triacrylate, tetraethylene glycol diacrylate, allyl acrylate, allyl methacrylate, diallyl acrylate, 1,6-hexanediol diacrylate, and diallyl maleate methacrylate.

According to particularly preferred embodiments of the present invention, the at least one ethylenically unsaturated polymerisable monomer will comprise from 10 to 100 % by weight (preferably 20 to 95 % by weight) of at least one acrylic and/or methacrylic functional monoethylenically unsaturated polymerisable monomer as hereinbefore defined, from 0 to 50 % by weight (preferably 5 to 50 % by weight) of at least one multi-functional ethylenically unsaturated polymerisable monomer having at least one acrylic or methacrylic double bond as hereinbefore defined, and from 0 to 50 % by weight (preferably 0 to 40 % by weight) of at least one further monomer, which further monomer does not contain an acrylate or methacrylate functionality, but which reacts with said acrylate and methacrylate functional monomers, e.g., N-vinyl pyrrolidone.

The at least one free-radical generating photoinitiator or photoinitiating system may consist of a single compound or may comprise at least two components which act together to form free-radicals on exposure to actinic radiation, so as to initiate polymerisation of the at least one ethylenically unsaturated poly-

7

merisable monomer. In most embodiments, the photoinitiator or photoinitiating system will be chosen from among the many useful photoinitiators or systems known in the art on the basis of its solubility, or at least dispersibility, in the photopolymerisable composition, its compatibility with the other components of the composition, and its effectiveness with the specific monomer(s). Other important considerations include, inter alia, the speed of the photoinitiator or system (i.e. the rate at which it will generate free-radicals to initiate polymerisation of at least one ethylenically unsaturated monomer), this is particularly important when the photopolymerisable compositions are to be used for the formation of hologram masters where high speed photoinitiators or systems are required. Suitable photoinitiators may include, inter alia, vicinal ketaldonyl compounds, e.g., diacetyl, benzil; alpha-ketaldonyl alcohols, e.g., benzoin, pivaloin; acyloin ethers, e.g., benzoin methyl and ethyl ethers; alpha-hydrocarbon-substituted aromatic acyloins, e.g., alpha-methylbenzoin, alpha-allylbenzoin, and alpha-phenylbenzoin. Other suitable photoinitiators may be chosen from the substituted or unsubstituted polynuclear quinones having two intracyclic carbonyl groups attached to intracyclic carbon atoms in a conjugated carbocyclic ring system, e.g., 9,10-anthraquinone. Suitable photoinitiating systems may include those which generate free-radicals by chemical reaction following a photochemical electron transfer reaction, e.g., dye sensitised photoinitiator systems.

The preferred photoinitiators or systems for use in the present invention are those which provide an efficient source of radicals when irradiated with visible light, for example, light of wavelength greater than 400 nm. Still more preferred photoinitiators or systems are those that are sensitive to the emissions from an Argon Ion laser which emits visible blue light (wavelength 488 nm). Particularly preferred photoinitiators or systems in this realm, are those comprising camphorquinone either as the sole catalyst or in combination with one or more other co-catalysts and/or synergists. By the term synergist, we mean a compound which cooperates with the at least one catalyst so as to assist in the generation of free-radicals. A suitable co-catalyst is benzil, and suitable synergists include, inter alia, organic peroxides, e.g., tert-butyl perbenzoate; alkyl tin carboxylic acid ester compounds, e.g., dibutyl tin dilaurate (DBTDL) and tributyl tin methacrylate (TBTMA); and tert-amines. The camphorquinone, the co-catalyst(s) and/or the synergist(s) may be used in any combination and in any proportion. However, particularly preferred photoinitiating systems include, camphorquinone in combination with tert-butyl perbenzoate such that the molar ratio of camphorquinone:tert-butyl perbenzoate is in the range 1:2 to 2:1 (preferably about 1:1), camphorquinone in combination with benzil and tert- butyl perbenzoate such that the molar ratio of camphorquinone:benzil:tert-butyl perbenzoate is about 1:1:2, camphorquinone in combination with dibutyl tin dilaurate or tributyl tin methacrylate such that the molar ratio of camphorquinone:dibutyl tin dilaurate or tributyl tin methacrylate is in the range 1:1 to 1:2 (preferably about 1:1.5), and camphorquinone in combination with benzil and dibutyl tin dilaurate or tributyl tin methacrylate such that the molar ratio of camphorquinone:benzil:dibutyl tin dilaurate or tributyl tin methacrylate is about 1:1:3. Photopolymerisable compositions comprising the preferred initiator systems employing camphorquinone may be used for recording hologram masters and hologram copies.

In forming the photopolymerisable compositions for use in the present invention, the at least one film-forming copolymer of the polymeric binder is normally formed by emulsion polymerisation techniques so as to form, at least in part, the aqueous latex of the film-forming polymeric binder. Alternatively, the film-forming copolymer may be formed by other addition polymerisation techniques, and then suspended in an aqueous medium to form, at least in part, the aqueous latex of the film-forming polymeric binder. The solids concentration of the polymeric binder in the aqueous latex will preferably be from 20 to 70 % by weight based on the total weight of the said aqueous latex (i.e the aqueous latex of the polymeric binder will preferably contain 20 to 70 % by weight of polymer solids). The at least one ethylenically unsaturated polymerisable monomer and the at least one photoinitiator or photoinitiating system may then be added to the aqueous latex of the film-forming polymeric binder, and should ideally be well dispersed or dissolved therein, so as to form a photopolymerisable composition of good consistency and homogeneity. The relative proportions of the polymeric binder, the polymerisable monomer(s), and the photoinitiator(s)/system(s) will normally be adjusted so that the polymeric binder comprises from 50 to 90 % (preferably from 75 to 90 %) by weight, the polymerisable monomer(s) from 5 to 40 % (preferably from 5 to 20 %) by weight, and the photoinitiator(s)/system(s) from 0.1 to 10 % (preferably 0.5 to 5 %) by weight based on the total dry weight of the photopolymerisable composition after removal of the aqueous phase to form a photosensitive element, such as a photosensitive film. The aqueous photopolymerisable compositions may optionally comprise other additives, for example, one or more further polymers of the non-film-forming type, external plasticisers to lower the effective glass transition temperature (Tg) of the polymeric binder to assist film-formation, one or more surfactants which may be employed to disperse and stabilise the polymeric binder in the aqueous phase and to assist in the dispersion of the polymerisable monomer(s) and photoinitiator(s)-system(s). In preferred embodiments, the aqueous photopolymerisable compositions will normally comprise one or more surfactants of one sort or another (in addition to any surfactant which may be used in an emulsion polymerisation to form the film-forming copolymer) which may be non-ionic or ionic in nature, in order to assist in achieving a uniform composition. Other additives which may be employed in the photopolymerisable compositions include, inter alia, thickeners, defoamers and wetting agents.

The photopolymerisable compositions may be formed into photosensitive elements, such as photosensitive films, by removing the aqueous phase from the said compositions. In forming a photosensitive film, the photopolymerisable composition is normally applied to a base support (preferably a flat rigid base support, for example, glass) and then dried to remove the aqueous phase (i.e. by natural drying, or by accelerated drying) in order to yield the said film. By a photosensitive film, we are intending to refer to a coherent layer of material suitable for recording an image (e.g., a holographic image). The photosensitive film will often be retained in position on a base support during exposure to form the image. Glass plates are particularly suitable as a base support, but other materials may equally be used. For example, suitable materials for a base support may include, inter alia, high polymers such as polyolefins, e.g., polyethylene; polyesters, e.g., polyethylene terephthalate; and cellulosics, e.g., cellulose acetate. The application of the photopolymerisable composition to the base support may be achieved by conventional coating techniques commonly employed in the art, for example, by brush coating, spray coating, roller coating or dipping. The thickness of the photosensitive film (when dry) is not critical and may be selected according to the intended use. However, for most practical applications, the dry film thickness will be in the range 0.1 to 2000 $\mu$m, and preferably within the range 1 to 100 $\mu$m. The photopolymerisable compositions for use in the invention may, after drying to remove the aqueous phase, form touch dry, coherent and transparent photosensitive films of good mechanical strength and dimensional stability, which are capable of recording holographic images of high intensity and good resolution. The photosensitive films may also be mechanically self supporting allowing for removal from the base support.

After evaporation of the aqueous phase, certain of the photosensitive elements may be somewhat soft and tacky (although this is not preferred). In such circumstances it may be desirable to apply a cover layer, which may be an additional coating or a previously case film, in order to provide a hard, dry, non-tacky surface and, therefore, facilitate storage and handling. The cover layer may be left in position until after formation of the image, or removed prior to exposure. However, if the cover layer also provides an oxygen barrier preventing the diffusion of oxygen into the photosensitive element, it may be desirable to leave the cover layer in position until after image formation, depending on the sensitivity of the photosensitive element to the polymerisation inhibiting effect of oxygen. Indeed, in view of the possible detrimental effect of oxygen, even for photosensitive elements that do not have a tacky surface, the application of a cover layer as a means to provide an oxygen barrier may sometimes be advantageous. If a cover layer is to be left in place until after image formation, the material selected should have good clarity and its thickness should be held to a minimum, so as not to interfere with the optical properties of the photosensitive element. After formation of the image, the cover layer, if used, may be removed if desired. However, with the most preferred photopolymerisable compositions, the photosensitive elements formed therefrom will not require a cover layer, either as a means to protect the photosensitive element, or as a means to provide an oxygen barrier.

In forming an image, a photosensitive element, such as a photosensitive film, is exposed imagewise to actinic radiation bearing image information, for example holographic information. The exposure step may be carried out in the absence of atmospheric oxygen (but not necessarily so), for example, by using a cover layer, or by effecting the exposure in an inert atmosphere or under vacuum.

In making hologram masters or copies, the optimum exposure time may be readily determined by routine testing, and may vary from a fraction of a second to several minutes depending, inter alia, on the intensity of the exposing radiation, the distance from the radiation source to the photosensitive element, the type and concentration of photoinitiator(s) or system(s), and the particular ethylenically unsaturated polymerisable monomer(s) chosen. As with other photosensitive materials, the photosensitive elements may be under exposed or over exposed, resulting in poor image quality. In the case of making hologram masters, the actinic radiation bearing holographic information consists of the interference pattern resulting from the interaction of the reference beam and the object beam (i.e. the light reflected from, or transmitted by, the object being illuminated). In the case of making hologram copies, the actinic radiation bearing holographic information consists of the actinic radiation transmitted from a source to the photosensitive element through a previously made hologram master. In either case, the actinic radiation employed must be able to activate the photoinitiator or system. The particularly preferred photoinitiators or systems exhibit their maximum sensitivity in the visible range, particularly the blue range, of the spectrum, and, therefore, when these preferred photoinitiators or systems are employed in the photopolymerisable compositions, the radiation source should furnish an effective amount of this radiation. It is to be understood, however, that photoinitiators or systems with maximum sensitivity at other wavelengths and corresponding radiation sources may also be used.

For the making of hologram masters it is essential to use highly coherent light of high intensity (i.e the type of light that is emitted by a laser) for the imagewise exposure. Therefore, in making hologram masters, it will be necessary to use a laser which emits light of a wavelength to which the photoinitiator or system in the photopolymerisable composition is sensitive. For example, when using the preferred photoinitiators or systems defined supra, with sensitivity in the blue region, it is particularly suitable to use the light emitted from an Argon Ion laser (as a source of actinic radiation) for the initial imagewise exposure.

For the making of hologram copies it is not necessary for the light to have a long coherence length. Suitable sources of actinic radiation include, inter alia, lasers, carbon arcs, mercury vapour arcs, and quartz iodide lamps. The angle at which the incident light from the radiation source strikes the hologram master and, through it, the photosensitive element is important. The best copies are achieved when the incident light strikes at an angle which corresponds, after correction for difference in wavelength, to the angle of incidence of the reference beam used in making the original hologram. However, it should be realised that copies can be made even when the angle of incidence of the light used for making the copy does not correspond to the angle of incidence of the original reference beam. When radiation sources with a short coherence length are employed for the copying, separation of the hologram master and the photosensitive element should be avoided altogether, since this will impair or even destroy the holographic image. When the actinic radiation is highly coherent, as from a laser, a separation between the hologram master and the photosensitive element can be tolerated without any significant reduction in the quality of the hologram copy.

When a photosensitive element, such as a photosensitive film is exposed imagewise to actinic radiation bearing image information (e.g., holographic information), the photoinitiator is activated in the exposed (imaged) areas, but not in the unexposed (non-imaged) areas. The at least one ethylenically unsaturated polymerisable monomer is therefore caused to polymerise in the exposed areas to form a photo-polymer. Accordingly, after the imagewise exposure, an imaged layer comprising a photo-polymer in the areas bearing image information is formed.

After the imagewise exposure it is often preferred (though it is not essential) to expose the photosensitive element to an overall uniform non-imagewise exposure (which polymerises the remaining monomer), to fix the image and enhance the quality thereof. Suitable sources of radiation for the non-imagewise exposure include, inter alia, white light, or even radiation of the same wavelength as that used in the initial imagewise exposure. It will, of course, be realised that where a subsequent non-imagewise exposure is employed, the radiation used must be able to activate the photoinitiator or system, so as to provide for the polymerisation of the remaining monomer. Whether a subsequent non-imagewise exposure is employed or not, the photopolymerisable compositions provide for the production of photosensitive elements on which holographic images can be recorded (whether a hologram master or copy) without the need for time consuming wet processing operations.

It will, of course, be realised that the photosensitive elements may be used to record images other than holographic images, for example, it may be used to record the image information in a beam of light.

Accordingly, the present invention further provides an imaged layer having areas bearing image information said layer comprising:

A) a film-forming polymeric binder said binder comprising at least one film-forming copolymer which has been formed by addition polymerisation and which comprises polymerised units derived from at least one ethylenically unsaturated comonomer which provides the basis of film-formability in said copolymer; and

B) in at least the areas bearing image information a photo-polymer formed by addition polymerisation of at least one non-gaseous, ethylenically unsaturated monomeric compound.

The photopolymerisable compositions and the photosensitive elements which are used in accordance with the present invention provide a quick and efficient method for the preparation of hologram masters and copies. However, in addition to their obvious application in image holography and security systems, the photosensitive elements find useful application in a number of other areas. For example, they may be used to record the interference pattern that results from the interaction of plane wave forms and, therefore, provide a simple low cost method for the manufacture of high quality diffraction gratings. Furthermore, the photosensitive elements may be used to make recorded copies of commercially available diffraction gratings by contact printing techniques. The photosensitive elements may also be used to record a variety of holographic optical elements, such as holographic lenses, and the filters in head up displays. Further possible applications for the photosensitive elements include holographic interferometry, optical data storage, image processing, and the manufacture of wave guides.

The present invention is now illustrated, but not limited, by the following examples in which, unless otherwise specified, all parts, percentages and ratios are on a weight basis.

## EXAMPLE 1

An aqueous based photopolymerisable composition was prepared as follows: A film-forming copolymer containing polymerised units of vinylidene chloride 85.0 %, acrylonitrile 4.5 %, acrylic acid 3.0 %, butyl acrylate 5.0 %, diallyl phthalate 2.0 %, and allyl methacrylate 0.5 %, was made by emulsion polymerisation to yield an aqueous latex of a polymeric binder (solids concentration about 59 %). The allyl methacrylate was added during an early part of the polymerisation reaction in order to effect a degree of crosslinking in the copolymer, and the diallyl phthalate was added during a late part of the polymerisation to provide the copolymer with residual ethylenic unsaturation. To this aqueous latex was added a 10:2 mixture of ethoxyethoxyethyl acrylate:trimethylolpropane triacrylate as the polymerisable monomers, and a 1:1 mixture of camphorquinone:tert-butyl perbenzoate as the photoinitiating system, so that the composition comprised 20 % (on copolymer weight) of the polymerisable monomers and 2 % (on copolymer weight) of the photoinitiating system. The photopolymerisable composition was coated on a glass support and then air dried to yield a transparent photosensitive film about 45 $\mu$m in thickness.

The photosensitive film was used to prepare a transmission holographic diffraction grating by recording the interference pattern that resulted from the interaction of two plane wave forms. The photosensitive film was given an initial imagewise exposure of 700 mJ/cm$^2$ using an Argon Ion laser, followed by a two minute delay, and then a final non-imagewise exposure to a flash light. The diffraction grating thus created was of good clarity and intensity, having a spatial frequency of 1600 lines/mm and a diffraction efficiency of 98 %.

## EXAMPLE 2

The same method and constituents as for Example 1 were used, except that the amount of the polymerisable monomers was 15 % on copolymer weight. The diffraction grating had a spatial frequency of 1600 lines/mm and a diffraction efficiency of 45 %.

## EXAMPLES 3,4 and 5

The aqueous based photopolymerisable compositions were prepared as follows: A film-forming copolymer containing polymerised units of vinylidene chloride 68.0 %, vinyl chloride 21.5 %, 2-ethylhexyl acrylate 6.0 %, methacrylic acid 2.0 %, diallyl phthalate 2.0 %, and allyl methacrylate 0.5 %, was made by emulsion polymerisation techniques to yield an aqueous latex of a polymeric binder (solids concentration about 59 %). As before, the allyl methacrylate was added during an early part of the polymerisation reaction to effect a degree of crosslinking in the copolymer, and the diallyl phthalate was added during a late part of the polymerisation to provide the copolymer with residual ethylenic unsaturation. To this aqueous latex was added a 10:2 mixture of ethoxyethoxyethyl acrylate:trimethylolpropane triacrylate as the polymerisable monomers, so that the composition comprised 20 % (on copolymer weight) thereof. The photoinitiating system employed, in each case, was a 1:1.5 mixture of camphorquinone:dibutyl tin dilaurate, except that different amounts thereof were used for each example (see Table 1). As before the photopolymerisable compositions were coated onto glass supports and then air dried to yield transparent photosensitive films of about 45 $\mu$m in thickness.

The photosensitive films were used to prepare transmission holographic diffraction gratings, and were given an initial imagewise exposure of actinic radiation using an Argon Ion laser, followed by a two minute delay, before a final non-imagewise exposure to a flash light. The intensity of the imagewise exposures used, and the diffraction efficiencies of the resulting holographic diffraction gratings are shown in Table 1. The spatial frequency of all the diffraction gratings was 1600 lines/mm.

## EXAMPLE 6

Exactly the same photopolymerisable composition as for Example 1 was employed. The photopolymerisable composition was coated on a glass support and then air dried to yield a transparent photosensitive film about 45 μm in thickness.

The film was used to prepare a transmission holographic diffraction grating, and was given an initial imagewise exposure of 600 mJ/cm² using an Argon Ion laser, followed by a two minute delay, before a final non-imagewise exposure to a flash light for 30 minutes. The diffraction grating thus created had a diffraction efficiency of 83 %, and was then placed in an oven at 72°C for 24 hours in order to investigate the temperature stability of the diffraction grating. After heating, the diffraction efficiency had increased from 83 % to 89 %, and the grating had retained its clarity and intensity.

EXAMPLE 7

An aqueous based photopolymerisable composition was prepared as follows: The same aqueous binder latex as for Examples 3 to 5 was used. The solids concentration of the aqueous latex was about 59 %, and to 6.3 g of this aqueous latex was added 3.0 g of a monomer/photoinitiator mix containing:

| n-butyl acrylate | 15.0 g |
|---|---|
| camphorquinone | 0.86g |
| benzil | 0.86g |
| di-n-butyl tin dilaurate | 1.29g |
| 25 % aqueous NP30 | 3.0g |
| water | 12.75g |

The photopolymerisable composition was coated on a glass support and then air dried to yield a transparent photosensitive film about 45 μm in thickness.

The photosensitive film was used to prepare a transmission holographic diffraction grating. The photosensitive film was given an initial imagewise exposure of 180 mJ/cm² using an Argon Ion laser, followed by a two minute delay, and then a final non-imagewise exposure to a flash light. The diffraction grating thus created had a spatial frequency of 1600 lines/mm and a diffraction efficiency of 44 %.

EXAMPLE 8

An aqueous based photopolymerisable composition was prepared as follows: The same aqueous binder latex as for Examples 3 to 5 was used. The solids concentration of the aqueous latex was about 59 %, and to 6.3 g of this aqueous latex was added 3.0 g of a monomer/

| n-butyl acrylate | 12.5 g |
|---|---|
| trimethylol propane triacrylate | 2.5g |
| camphorquinone | 0.86g |
| benzil | 0.86g |
| di-n-butyl tin dilaurate | 1.29g |
| 25 % aqueous NP30 | 3.0g |
| water | 12.75g |

The photopolymerisable composition was coated on a glass support and then air dried to yield a transparent photosensitive film about 45 μm in thickness.

The film was used to prepare a transmission holographic diffraction grating, and was given an initial imagewise exposure of 120 mJ/cm² using an Argon Ion laser, followed by a two minute delay, before a final non-imagewise exposure to a flash light. The diffraction grating thus created had a spatial frequency of 1600 lines/mm and a diffraction efficiency of 24 %.

EXAMPLE 9

An aqueous based photopolymerisable composition was prepared as follows: The same aqueous binder

12

latex as for Examples 3 to 5 was used. The solids concentration of the aqueous latex was about 59 %, and to 6.3 g of this aqueous latex was added 0.15 g of a monomer/photoinitiator mix containing:

| | |
|---|---|
| ethoxyethoxyethyl acrylate: | 0.69 g |
| trimethylolpropane triacrylate | 0.124 g |
| camphorquinone | 0.25 g |
| benzil | 0.25 g |
| ethyl-4-(dimethylamino)benzoate | 0.323 g |

The photopolymerisable composition was coated on a glass support and then air dried to yield a transparent photosensitive film about 45 μm in thickness.

The film was used to prepare a transmission holographic diffraction grating, and was given an initial imagewise exposure of 100 mJ/cm² using an Argon Ion laser, followed by a two minute delay, before a final non-imagewise exposure to a flash light. The diffraction grating thus created had a spatial frequency of 1600 lines/mm and a diffraction efficiency of 12 %.


EXAMPLE 10

An aqueous based photopolymerisable composition was prepared as follows: The same aqueous binder latex as for Examples 3 to 5 was used. The aqueous latex was neutralised to pH 7 with concentrated aqueous ammonia solution. The solids concentration of the aqueous latex was about 59 %, and to 6.3 g of the neutralised latex was added 0.15 g of a monomer/photoinitiator mix containing:

| | |
|---|---|
| ethoxyethoxyethyl acrylate: | 0.69 g |
| trimethylolpropane triacrylate | 0.124 g |
| camphorquinone | 0.25 g |
| benzil | 0.25 g |
| N, N - dimethylaminoethylmethacrylate | 0.325 g |

The photopolymerisable composition was coated on a glass support and then air dried to yield a transparent photosensitive film about 45 μm in thickness.

The film was used to prepare a transmission holographic diffraction grating, and was given an initial imagewise exposure of 230 mJ/cm² using an Argon Ion laser, followed by a two minute delay, before a final non-imagewise exposure to a flash light. The diffraction grating thus created had a spatial frequency of 1600 lines/mm and a diffraction efficiency of 22 %.


EXAMPLE 11

An aqueous based photopolymerisable composition was prepared as follows: A film-forming copolymer containing polymerised units of vinylidene chloride 85.3 %, acrylonitrile 3.8 %, acrylic acid 3.8 %, butyl acrylate 4.7 %, diallyl phthalate 1.9 %, and allyl methacrylate 0.47 %, was prepared by emulsion polymerisation to yield an aqueous latex of a polymeric binder. The allyl methacrylate was added during an early part of the polymerisation reaction in order to effect a degree of crosslinking in the copolymer, and the diallyl phthalate was added during a late part of the polymerisation to provide the copolymer with residual ethylenic unsaturation. The solids concentration of the aqueous latex was about 59 %, and to 5.5 g of this latex was added 0.65 g of a monomer/photoinitiator mix containing:

| | |
|---|---|
| ethoxyethoxyethyl acrylate: | 0.54 g |
| trimethylolpropane triacrylate | 0.11 g |
| camphorquinone | 0.25 g |
| t-butylperbenzoate | 0.25 g |

The photopolymerisable composition was coated on a glass support and then air dried to yield a

13

transparent photosensitive film which was used to make a holographic diffraction grating as usual. A diffraction grating having a spatial frequency of 1600 lines/mm and a diffraction efficiency of 30 % was obtained using an exposure of 125 mJ/cm².

EXAMPLE 12

An aqueous based photopolymerisable composition was prepared as follows: A film-forming copolymer containing polymerised units of vinylidene chloride 74 %, vinyl chloride 19 %, 2-ethylhexyl acrylate 5.2 %, acrylic acid 1.8 %, was prepared by emulsion polymerisation to yield an aqueous latex of a polymeric binder (solids concentration about 59 %). The resulting copolymer was not crosslinked and did not contain any residual ethylenic unsaturation. To 5.8 g of this aqueous latex was added 0.69 g of a monomer/photoinitiator mix containing:

| ethoxyethoxyethyl acrylate: | 0.57 g |
|---|---|
| trimethylolpropane triacrylate | 0.11 g |
| camphorquinone | 0.25 g |
| t-butylperbenzoate | 0.25 g |

A photosensitive film was made and exposed as before. A diffraction grating having a spatial frequency of 1600 lines/mm and a diffraction efficiency of 20 % was obtained using an exposure of 400 mJ/cm².

TABLE 1

| Example | Catalyst percentage (on copolymer weight) | Exposure Intensity | Diffraction Efficiency |
|---|---|---|---|
| 3 | 1.0 % | 394 mJ/cm² | 68 % |
| 4 | 2.0 % | 230 mJ/cm² | 70 % |
| 5 | 4.0 % | 95 mJ/cm² | 60 % |

**Claims**

1. The use of an aqueous-based, film-forming, photopolymerisable composition for the formation of photosensitive elements on which image information is to be recorded, said composition comprising:

A) an aqueous latex of a film-forming polymeric binder said binder comprising at least one film-forming copolymer formed by addition polymerisation, said film forming copolymer comprising polymerised units derived from at least one ethylenically unsaturated comonomer which provides the basis of film-formability in said copolymer;

B) at least one non-gaseous, ethylenically unsaturated monomeric compound compatible with the polymeric binder of (A) and which is capable of forming a polymer by free-radical initiated addition polymerisation; and

C) at least one free radical-generating photoinitiator or photoinitiating system activatable by a source of actinic radiation for the polymerisation of the at least one monomer of (B).

2. The use of an aqueous-based, film-forming, photopolymerisable composition as claimed in claim 1 wherein said at least one film-forming copolymer further comprises polymerised units derived from at least one multi-functional comonomer incorporated to provide a degree of cross-linking in said copolymer.

3. The use of an aqueous-based, film-forming, photopolymerisable composition as claimed in claim 2 wherein the film-forming copolymer comprises from 0.1 to 20 % by weight of polymerised units derived from the at least one multi-functional comonomer incorporated to provide a degree of cross-linking in said copolymer.

EP 0 342 812 A2

4. The use of an aqueous-based, film-forming, photopolymerisable composition as claimed in claim 2 or claim 3 wherein the film-forming copolymer has a gel fraction in the range of from 5 to 80% by weight.

5. The use of an aqueous-based, film-forming, photopolymerisable composition as claimed in any one of the preceding claims wherein the film-forming copolymer comprises polymerised units derived from at least one monoethylenically unsaturated monomer of the film-forming type containing an olefinic, vinyl, vinylidene, acrylic or methacrylic double bond.

6. The use of an aqueous-based, film-forming, photopolymerisable composition as claimed in any one of the preceding claims wherein the film-forming copolymer is a chlorine-containing copolymer comprising polymerised units derived from at least one chlorine-containing comonomer.

7. The use of a composition as claimed in claim 6 wherein the film-forming copolymer comprises from 5 to 95 % by weight of polymerised units derived from the at least one chlorine-containing comonomer.

8. The use of an aqueous-based, film-forming, photopolymerisable composition as claimed in claim 6 or claim 7 wherein said at least one chlorine containing comonomer is selected from one or both of vinylidene chloride and vinyl chloride.

9. The use of a composition as claimed in claim 8 wherein polymerised units of vinylidene chloride provide at least 50 % by weight of the chlorine-containing comonomer content of the film-forming copolymer.

10. The use of an aqueous-based, film-forming, photopolymerisable composition as claimed in claim 8 or claim 9 wherein the film-forming copolymer comprises polymerised units derived from at least one alkyl acrylate and/or methacrylate having from 1 to 12 carbon atoms in the alkyl group.

11. The use of a composition as claimed in claim 10 wherein at least one of said at least one alkyl acrylate and/or methacrylate is an internally plasticising comonomer.

12. The use of an aqueous-based, film-forming, photopolymerisable composition as claimed in any one of claims 8 to 11 wherein said film-forming copolymer further comprises polymerised units derived from acrylonitrile and/or methacrylonitrile.

13. The use of an aqueous-based, film-forming, photopolymerisable composition as claimed in any one of claims 8 to 12 wherein said film-forming copolymer further comprises polymerised units derived from acrylic acid and/or methacrylic acid.

14. The use of an aqueous-based, film-forming, photopolymerisable composition as claimed in any one of the preceding claims wherein said film-forming copolymer comprises residual carbon to carbon double bond unsaturation.

15. The use of an aqueous-based, film-forming, photopolymerisable composition as claimed in claim 14 wherein said film-forming copolymer comprises polymerised units derived from at least one lower reactivity multi-functional comonomer incorporated to provide said residual carbon to carbon double bond unsaturation in said copolymer.

16. The use of an aqueous-based, film-forming, photopolymerisable composition as claimed in claim 15 wherein said film-forming copolymer comprises from 0.1 to 10 % by weight of polymerised units derived from the at least one lower reactivity multi-functional comonomer incorporated to provide said residual carbon to carbon double bond unsaturation in said copolymer.

17. The use of an aqueous-based, film-forming, photopolymerisable composition as claimed in claim 14 wherein said residual carbon to carbon double bond unsaturation is incorporated in said film-forming copolymer in a post-reaction step.

18. The use of an aqueous-based, film-forming, photopolymerisable composition as claimed in any one of the preceding claims wherein component (B) comprises at least two non-gaseous, ethylenically unsaturated addition-copolymerisable monomers, wherein at least one of said monomers is a monoethylenically unsaturated monomer and at least one of said monomers is a multi-functional monomer.

19. The use of an aqueous-based, film-forming, photopolymerisable composition as claimed in any one of the preceding claims wherein at least one of said at least one ethylenically unsaturated monomer of (B) is a monoethylenically unsaturated monomer selected from the group consisting of alkyl acrylates and methacrylates having from 1 to 12 carbon atoms in the alkyl group, alkoxyalkyl and hydroxyalkyl acrylates and methacrylates having from 1 to 12 carbon atoms in the alkyl group and substituted alkyl acrylates and methacrylates having from 1 to 12 carbon atoms in the alkyl group.

20. The use of an aqueous-based, film-forming, photopolymerisable composition as claimed in any one of the preceding claims wherein at least one of said at least one ethylenically unsaturated monomer of (B) is a multi-functional monomer in which at least one of the carbon to carbon double bonds is an acrylic or methacrylic double bond.

15

21. The use of an aqueous-based, film-forming, photopolymerisable composition as claimed in any one of the preceding claims wherein said at least one free radical-generating photoinitiator or photoinitiating system of (C) comprises camphorquinone.

22. The use of a composition as claimed in claim 21 wherein said at least one free radical-generating photoinitiator or photoinitiating system comprises at least one co-catalyst.

23. The use of a composition as claimed in claim 21 or claim 22 wherein said at least one free radical-generating photoinitiator or photoinitiating system comprises at least one synergist.

24. The use of a photosensitive element prepared from an aqueous-based, film-forming, photopolymerisable composition as claimed in any one of the preceding claims for the recording of image information.

25. The use of a photosensitive element as claimed in claim 24 wherein the photosensitive element is in the form of a photosensitive film.

26. The use of a photosensitive film as claimed in claim 25 wherein the photosensitive film is a cover layer on a supporting substrate.

27. An imaged layer prepared from a photosensitive element as claimed in any one of claims 24 to 26 by a process which comprises at least the step of exposing said photosensitive element to actinic radiation bearing image information.

28. An imaged layer having areas bearing image information said layer comprising:

A) a film-forming polymeric binder said binder comprising at least one film-forming copolymer which has been formed by addition polymerisation and which comprises polymerised units derived from at least one ethylenically unsaturated comonomer which provides the basis of film-formability in said copolymer; and

B) in at least the areas bearing image information a photo-polymer formed by addition polymerisation of at least one non-gaseous, ethylenically unsaturated monomeric compound.

29. An image bearing layer as claimed in claim 28 wherein said at least one film-forming copolymer further comprises polymerised units derived from at least one multi-functional comonomer incorporated to provide a degree of crosslinking in said copolymer.

30. An image bearing layer as claimed in claim 28 or claim 29 wherein said film-forming copolymer comprises polymerised units derived from one or both of vinylidene chloride and vinyl chloride.

31. An image bearing layer as claimed in claim 30 wherein the film-forming copolymer comprises polymerised units derived from at least one alkyl acrylate and/or methacrylate having from 1 to 12 carbon atoms in the alkyl group.

32. An image bearing layer as claimed in claim 31 wherein said film-forming copolymer further comprises polymerised units derived from acrylonitrile and/or methacrylonitrile.

33. An image bearing layer as claimed in claim 31 or claim 32 wherein said film-forming copolymer further comprises polymerised units derived from acrylic acid and/or methacrylic acid.

34. An image bearing layer as claimed in claims 28 to 33 wherein the photo-polymer comprises polymerised units derived from at least one monoethylenically unsaturated monomer and at least one multi-functional monomer.

35. An image bearing layer as claimed in claims 28 to 34 wherein the photo-polymer comprises polymerised units derived from at least one monoethylenically unsaturated monomer selected from the group consisting of alkyl acrylates and methacrylates having from 1 to 12 carbon atoms in the alkyl group, alkoxyalkyl and hydroxyalkyl acrylates and methacrylates having from 1 to 12 carbon atoms in the alkyl group and substituted alkyl acrylates and methacrylates having from 1 to 12 carbon atoms in the alkyl group.

36. An image bearing layer as claimed in claims 28 to 35 wherein the photo-polymer comprises polymerised units derived from at least one multi-functional monomer in which at least one of the carbon to carbon double bonds is an acrylic or methacrylic double bond.

37. An image bearing layer as claimed in any one of claims 28 to 36 which is a self supporting layer.

38. An image bearing layer as claimed in any one of claims 28 to 36 carried on a transparent supporting substrate.

39. An image bearing layer as claimed in any one of claims 28 to 38 wherein the image is a holographic image.

40. An image bearing layer as claimed in claim 39 when used as an optical element.